(19) Europäisches Patentamt
European Patent Office
Office européen des brevets

(11) **EP 3 284 061 B1**

(12) **EUROPEAN PATENT SPECIFICATION**

(45) Date of publication and mention of the grant of the patent:
**10.11.2021 Bulletin 2021/45**

(21) Application number: **15889406.3**

(22) Date of filing: **17.04.2015**

(51) Int Cl.:
*G06T 7/593* *(2017.01)*    *H04N 5/232* *(2006.01)*
*H04N 9/04* *(2006.01)*

(86) International application number:
**PCT/US2015/026545**

(87) International publication number:
**WO 2016/167814 (20.10.2016 Gazette 2016/42)**

(54) **SYSTEMS AND METHODS FOR PERFORMING HIGH SPEED VIDEO CAPTURE AND DEPTH ESTIMATION USING ARRAY CAMERAS**

SYSTEME UND VERFAHREN ZUR DURCHFÜHRUNG EINER HOCHGESCHWINDIGKEITSVIDEOERFASSUNG UND -TIEFENSCHÄTZUNG MIT ARRAY-KAMERAS

SYSTÈMES ET PROCÉDÉS POUR EFFECTUER UNE CAPTURE VIDÉO ET UNE ESTIMATION DE PROFONDEUR À GRANDE VITESSE AU MOYEN DE CAMÉRAS À MOSAÏQUE DE CAPTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.02.2018 Bulletin 2018/08**

(73) Proprietor: **FotoNation Limited**
**Ballybrit, Galway H91R2E9 (IE)**

(72) Inventors:
• **VENKATARAMAN, Kartik**
**San Jose, CA 95121 (US)**
• **HUANG, Yusong**
**Santa Clara, CA 95050 (US)**
• **JAIN, Ankit**
**Mountain View, CA 94040 (US)**

• **CHATTERJEE, Priyam**
**Sunnyvale, CA 94086 (US)**

(74) Representative: **Hanna Moore + Curley**
**Garryard House**
**25-26 Earlsfort Terrace**
**Dublin 2, D02 PX51 (IE)**

(56) References cited:
**WO-A1-2011/121117    US-A1- 2008 044 170**
**US-A1- 2011 080 487    US-A1- 2011 255 786**
**US-A1- 2012 307 084    US-A1- 2013 216 144**
**US-A1- 2013 293 760    US-A1- 2014 267 243**
**US-A1- 2014 267 633    US-A1- 2014 267 762**

• **None**

**Description**

FIELD OF THE INVENTION

The present invention generally relates to digital cameras and more specifically to systems and methods for capturing video and images using array cameras.

BACKGROUND

High speed videography using camera arrays has been proposed by Schechtman et al. "Increasing Space-Time Resolution in Video," European Conference on Computer Vision (ECCV), May 2002 and Wilburn et al. "High-Speed Videography using a Dense Camera Array" IEEE Society Conference on Pattern Recognition, 2004.

The Wilburn et al. paper disclosed that creating a single high-speed video sequence involves aligning the cameras in the array to a reference viewpoint and notes that this is a difficult task. Accordingly, the Wilburn et al. paper proposes using a simplifying assumption that the imaged scene lies within a shallow depth of a single object plane. The Wilburn et al. paper notes that this assumption only holds for scenes that are either relatively flat or sufficiently far from the array relative to the camera spacing. Where the assumption does not hold true, the Wilburn et al. paper notes that objects off the focal plane remain sharp but appear to move from frame to frame of the aligned images due to the alignment errors.

The alignment errors are a function of the incorrect estimation of depth for objects within the scene that do not lie on the single object plane. Binocular viewing of a scene creates two slightly different images of the scene due to the different fields of view of each eye. These differences are referred to as binocular disparity (or parallax). Shifts due to parallax can be corrected for with knowledge of the depth of the object and the baseline between the cameras that image the scene. When all objects are assumed to be on the same plane, alignment errors result for objects that do not lie on the plane. The Wilburn et al. paper proposes minimizing the alignment errors by capturing image data sequentially using spatially adjacent cameras. In this way, the maximum alignment error is constrained.

The camera array described in the Wilburn et al. paper utilizes inexpensive CMOS sensors that have an electronic rolling shutters. A snap-shot shutter starts and stops light integration for every pixel in a sensor at the same time. Sample and hold circuitry is then utilized to enable sequential readout. An electronic rolling shutter exposes each row just before it is read out, which eliminates the need for sample and hold circuitry. The Wilburn et al. paper identifies that a disadvantage of using sensors with rolling shutters for high speed video capture is that the rolling shutter can distort the shape of fast moving objects. Effectively, pixels near the bottom of a frame start and stop integration of light almost a frame later than pixels from the top of the frame.

US2011/080487 discloses a system including array cameras and configured to perform super-resolution processing to generate higher resolution super-resolved images using a plurality of captured images and lens stack arrays.

WO2011/121117 discloses a virtual camera system comprising a plurality of physical cameras and a hardware setup running software to determine a virtual viewpoint from a plurality of images captured by the plurality of cameras, the images comprising current frames and previous frames. In particular, background frames are obtained by combining a set of previous frames, and a plurality of foreground masks are obtained by performing segmentation on current frames. The segmentation comprises separating foreground objects from background objects using the obtained background frames. The foreground objects are rendered by using a three-dimensional depth-box constrained viewpoint interpolation algorithm on the plurality of current frames. A view-dependent background image is rendered by performing homographic transformations on the created background frames. A virtual viewpoint is obtained by superimposing the rendered foreground objects on the rendered background frame.

SUMMARY OF THE INVENTION

The invention is an array camera according to claim 1. Embodiments of the array camera are defined in claims 2-8. The invention and its embodiments can be used to perform high speed video capture and depth estimation. A need exists for a system for estimating depth while performing high speed video capture using an array camera to reduce alignment errors resulting from objects located at different depths within a scene. As can readily be appreciated, real world scenes typically include objects located at different distances from a camera. Therefore, estimating depth during video capture by an array of cameras can result in smoother rendering of video from image data captured of real world scenes. Array cameras in accordance with embodiments of the invention can incorporate sensors with snap-shot shutters and/or sensors with rolling shutters. The specific technique for estimating depth and rendering high frame rate video sequences typically depends on the number, type and shutter speed of the cameras in the array. In addition, when an array is formed by the assembly of independent camera modules, the relative rolling shutter between the cameras can be minimized during read-out as compared to an array formed on a single common substrate having a common readout from the independent sub-arrays on the substrate. This type of array construction can further minimize alignment errors.

BRIEF DESCRIPTION OF THE DRAWINGS

FIG. 1 conceptually illustrates an array camera in accordance with an embodiment of the invention.

FIG. 2 conceptually illustrates an optic array and an imager array in an array camera module in accordance with an embodiment of the invention.

FIG. 3A conceptually illustrates a layout of color filters, camera groups used when performing high speed video capture, and the location of a reference camera in an array camera module in accordance with an embodiment of the invention.

FIG. 3B conceptually illustrates a layout of color filters, and a camera group used to estimate depth of non-moving portions of a scene in an array camera module in accordance with an embodiment of the invention.

FIGS. 4A - 4C conceptually illustrate the disparity associated with the effects of parallax in two images of a scene captured from a reference viewpoint and an alternate viewpoint.

FIG. 5 is a flow chart illustrating a process for rendering a high speed video sequence using image data captured by an array camera in accordance with an embodiment of the invention.

FIG. 6A illustrates the timing of image data capture by four different groups of cameras within an array camera in accordance with an embodiment of the invention.

FIG. 6B illustrates the timing of display of frames rendered by a processor configured by an image processing pipeline application using image data captured by an array camera in accordance with an embodiment of the invention.

FIG. 6C illustrates the timing of image data capture by an array camera involving capture of image data using a first group of cameras that can be used to estimate depths of non-moving portions of a scene and subsequent image data capture by four different groups of cameras that can be used to estimate depth to moving pixels and render a high frame rate video sequence in accordance with an embodiment of the invention.

FIG. 6D illustrates the timing of image data capture by an array camera involving capture in which more than 1/N of the total number of rows (or columns) of a rendered frame are read out from each of N groups of cameras during a frame capture time interval to accommodate vertical parallax observable between the viewpoints of the cameras in the different groups of cameras in accordance with an embodiment of the invention.

FIG. 6E illustrates the use of image data captured during adjacent frame capture time intervals to render a frame of video from image data captured by each of N groups of cameras in a camera array to accommodate vertical parallax observable between the viewpoints of the cameras in the different groups of cameras in accordance with an embodiment of the invention.

FIG. 7 is a flow chart illustrating a process for estimating depth of moving pixels within image data captured by an array camera in accordance with an embodiment of the invention.

DETAILED DESCRIPTION

Turning now to the drawings, systems and methods for rendering high frame rate video sequences using image data captured by different groups of cameras within an array camera in accordance with an embodiment of the invention are illustrated. Video sequences typically have frame rates in the order of 24 frames per second (fps) or 30 fps. A frame rate in excess of 60 fps can be considered to be so-called "high frame rate" video. In the context of the array cameras discussed herein, high frame rate video is considered to be video in which the rate at which frames are rendered is faster than the rolling shutter speed used by the array camera when reading out data from a single camera or group of cameras within the array. By way of example, an array camera may be able to read out image data from each of four groups of cameras at the rate of 30 fps and render a high speed video sequence from the four sets of image data at 120 fps. By appropriately staggering the start times of image data capture by each of the groups of cameras, the array camera is able to synthesize a high speed video sequence at 120 fps. As can readily be appreciated, any of a variety of rolling shutter speeds and frame rates can be utilized in the synthesis of a high frame rate video sequence as appropriate to the requirements of specific applications in accordance with embodiments of the invention.

Video sequences, where the rolling shutter speed of the cameras in an array camera is less than the frame rate of the video, can be rendered using techniques such as those described in U.S. Patent 8,619,082 entitled "Systems and Methods for Parallax Detection and Correction in Images Captured using Array Cameras that Contain Occlusions using Subsets of Images to Perform Depth Estimation" to Ciurea et al., issued December 31, 2013 and U.S. Patent Publication No. 2014/0267243 entitled "Systems and Methods for Synthesizing Images from Image Data Captured by an Array Camera Using Restricted Depth of Field Depth Maps In which Depth Estimation Precision Varies" to Venkataraman et al., published September 18, 2014. Video sequences can be rendered at frame rates that are higher than the rolling shutter speed by using different groups within an array of cameras to capture image data in a staggered manner. The image data from the different groups of cameras can be used to render different portions of a frame during each frame capture time. Each of the groups of cameras, however, views the imaged scene from different perspectives resulting in parallax. In several embodiments of the invention, the process of rendering a high frame rate video sequence involves generating depth estimates for some or all of the objects visible within a scene and using the depth estimates to correct for parallax present in the images captured by each of the cameras within the array. By estimating depth instead of requiring moving objects be located a specified distance from the array of cameras, array cameras in accordance with many embodiments of the invention can image natural scenes including moving objects at arbitrary depths and/or moving objects at multiple different depths within a scene.

In a number of embodiments, a high frame rate video sequence is rendered by capturing an initial frame from a reference viewpoint and detecting pixels in images captured during successive frame capture time intervals that are moving. In several embodiments, detecting moving pixels involves inspecting successive frames captured from a specific viewpoint and detecting pixels with differences in intensity exceeding a threshold. Note that the above process involves detection of movement over the period of a rolling shutter time interval (as opposed to a frame capture interval). Depending upon the requirements of specific applications, a motion detection threshold may be predetermined and/or determined based upon the local characteristics of the image data. Successive frames of video are then rendered by compositing the moving pixels with the initial frame rendered from the reference viewpoint. The compositing process can involve shifting pixels from alternate viewpoints into the reference viewpoint. In order to shift the moving pixels into the reference viewpoint, the depths of the moving pixels can be estimated. In several embodiments, an initial determination is made concerning the pixels that are moving and non-moving pixels are shifted to align with the reference camera to avoid artifacts in the final composited image.

In embodiments where multiple cameras within a group of cameras form a stereo pair or a larger array of cameras from which depth estimates can be made, techniques similar to those described in U.S. Patent 8,619,082 and U.S. Patent Publication No. 2014/0267243 can be utilized to estimate the depths of moving pixels. In embodiments in which depth estimates cannot be reliably made using image data captured by a single group of cameras, then depth estimation can be performed by observing the disparity between moving pixels in image data captured by different groups of cameras having staggered start capture times. In certain embodiments, all moving pixels are assumed to be at the same depth. In several embodiments, clusters of moving pixels are identified and the pixels within each cluster of moving pixels are assumed to be at the same depth (although the depths of pixels in different clusters may vary).
In many embodiments, the depth of moving pixels visible from a first viewpoint is estimated by interpolating a frame or a portion of a frame from a second viewpoint based upon the frame capture time interval during which the image data from the first viewpoint was captured and using image data captured from the second viewpoint at other times. In this context, the frame capture time interval refers to the time interval during which image data is captured by multiple groups of cameras and used to render a single frame in the high speed video sequence. The locations of the moving pixels visible from the first viewpoint and the estimated locations of moving pixels visible from the second viewpoint at the relevant frame capture time can then be compared to estimate the depth of the moving pixels based upon disparity. The estimated disparity includes a component associated with the depth of the object and a component related to the motion of the object between frame captures. Accordingly, a measure can be utilized that minimizes the perceived shift due to motion and eliminates shift due to parallax. In many embodiments, an image from the second viewpoint is interpolated using image data captured from the second viewpoint at time intervals before and after the relevant frame capture time interval in which the image data from the first viewpoint was captured. When the first viewpoint is an alternate viewpoint to the reference viewpoint from which the initial frame of video is rendered, the reference viewpoint is typically selected as the second viewpoint from which to interpolate a frame. In embodiments in which the groups of cameras include cameras that capture image data in separate color channels, depth estimates for moving pixels captured from the reference viewpoint (e.g. a Green camera with a viewpoint selected as the reference viewpoint) can be useful in fusing moving pixels from other color channels captured by cameras within the group of cameras containing the reference camera. Accordingly, depth estimates can be determined when the first viewpoint is the reference viewpoint by interpolating a frame or portion of a frame of video from a second viewpoint that is an alternate viewpoint to the reference viewpoint. In other embodiments, any of a variety of techniques can be utilized to estimate the depths of moving pixels by performing disparity searches using image data captured by an array camera as appropriate to the requirements of specific applications.
Disparity searches can be performed comparing the similarity of pixels from different viewpoints along one or more epipolar lines. The comparisons are typically performed between a reference viewpoint and an alternate viewpoint however, any set of viewpoints can be utilized when performing disparity searches. In a number of embodiments, disparity searches involve determining the disparity at which the moving pixels from a first viewpoint exhibit the highest correlation with moving pixels from a second viewpoint. In certain embodiments, disparity searches are performed with respect to individual clusters of moving pixels based upon the disparity at which a cluster of moving pixels visible from the first viewpoint exhibits the highest correlation with a cluster of moving pixels visible from the second viewpoint. In a number of embodiments, depth estimates are made for individual moving pixels or smaller blocks of moving pixels using cost metrics such as (but not limited to) sum of absolute differences and/or the cost functions described in U.S. Patent 8,619,082 and U.S. Patent Publication No. 2014/0267243. In addition, depth estimates can be obtained using pixels that are visible from two or more different viewpoints.

The depths of moving pixels can be utilized to determine scene-dependent geometric corrections to apply to the moving pixels observed from alternate viewpoints to shift the moving pixels to a reference viewpoint. A new frame of video can then be rendered by compositing any moving pixels observed from the reference viewpoint with moving pixels shifted from alternate viewpoints into the reference viewpoint and non-moving pixels from a frame previously rendered from the reference viewpoint.

In a number of embodiments, the groups of cameras include single cameras that capture image data in a single color channel (e.g. a monochrome white camera, or an infrared camera) or in multiple color channels (e.g. a camera utilizing a Bayer color filter). In several embodiments, the groups of cameras include multiple cameras. In certain embodiments that utilize multiple monochrome cameras in different color channels (e.g. a Red camera, a Green camera, and a Blue camera), the rendering of non-moving pixels including intensity components in each of the color channels can also involve estimating depth in order to be able to shift the pixels into the reference viewpoint. Accordingly, array cameras in accordance with many embodiments of the invention also estimate depth for non-moving pixels in the reference frame. In a number of embodiments, the depths of non-moving pixels within a scene can be estimated from image data captured by the different groups of cameras in the array camera over a timer interval that is longer than a single frame capture time interval. Unlike moving pixels, the non-moving pixels can be assumed stationary through the entire time period during which an entire frame of image data is captured by the different cameras in the array of cameras. Therefore, disparity searches can be performed across an entire set of image data captured by the different groups of cameras over one or more rolling shutter intervals using techniques similar to those described in U.S. Patent 8,619,082 and U.S. Patent Publication No. 2014/0267243. In a number of embodiments that include cameras that capture image data in separate color channels, an initial depth map is estimated by capturing an initial frame or sequence of frames using a sufficiently large number of cameras so that multiple images are captured in each color channel. Ideally, the number of cameras is sufficiently large so that a camera in each color channel is distributed around the reference viewpoint and so that each pixel captured from the reference viewpoint is visible in at least one image captured from an alternate viewpoint in each color channel. Processes similar to those described in U.S. Patent 8,619,082 and U.S. Patent Publication No. 2014/0267243 can then be utilized to generate an initial depth map with respect to the non-moving pixels. Once the depth map is obtained, depths in the depth map can be assigned to non-moving pixels and the depths in the depth map for moving pixels can be determined using the processes described above and utilized to update the depth map. In several embodiments, the depths from the initial depth map can be used to bound disparity searches with respect to moving pixels.

In certain embodiments, the process of estimating depth also involves generation of a confidence metric that encodes one or more confidence factors. The manner in which an image processing application utilizes depth estimates in the rendering of a video sequence can be dependent upon the confidence of the depth estimate.

Systems and methods for rendering high frame rate video sequences using image data captured by array cameras in accordance with various embodiments of the invention are discussed further below. Array Cameras

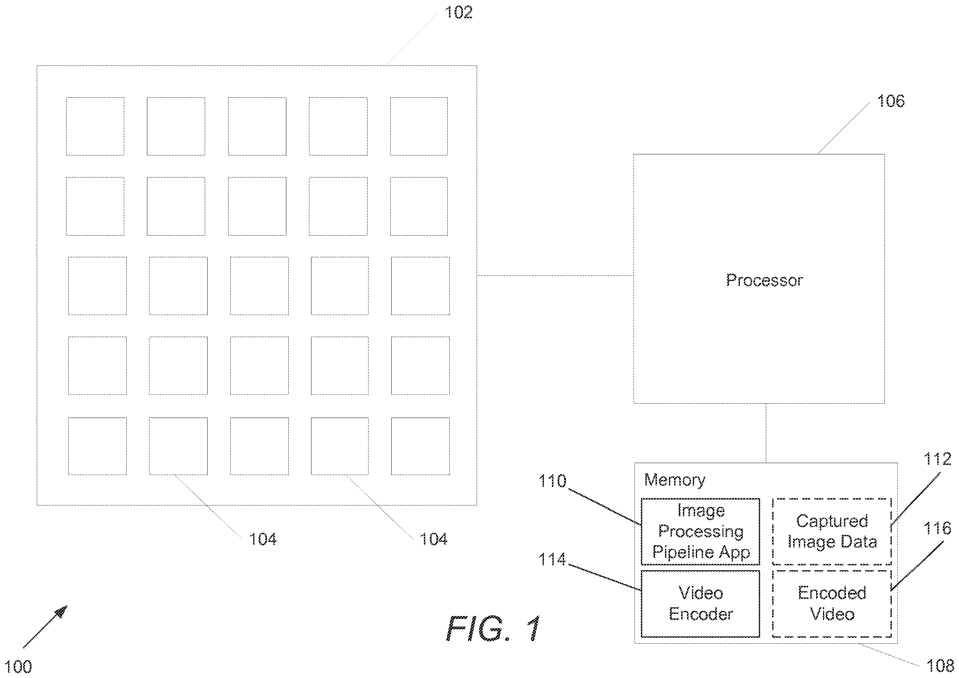

Array cameras in accordance with many embodiments of the invention can include an array camera module including an array of cameras and a processor configured to read out and process image data from the camera module to synthesize images. An array camera in accordance with an embodiment of the invention is illustrated in FIG. 1. The array camera 100 includes an array camera module 102 with an array of individual cameras 104, where an array of individual cameras refers to a plurality of cameras in a particular arrangement, such as (but not limited to) the square arrangement utilized in the illustrated embodiment. In other embodiments, any of a variety of grid or non-grid arrangements of cameras can be utilized. Various array camera configurations including monolithic and monolithic arrays incorporating various different types of cameras are disclosed in U.S. Patent Publication No. 2011/0069189 entitled "Capturing and Processing of Images Using Monolithic Camera Array with Heterogeneous Imagers" to Venkataraman et al. The array camera module 102 is connected to the processor 106. The processor is also configured to communicate with one or more different types of memory 108 that can be utilized to store an image processing pipeline application 110, image data 112 captured by the array camera module 102, a video encoder 114 and encoded video 116. The image processing pipeline application 110 is typically non-transitory machine readable instructions utilized to direct the processor to perform processes including (but not limited to) the various processes described below. In several embodiments, the processes include coordinating the staggered capture of image data by groups of cameras within the array camera module 102, the estimation of depth information from the captured image data 112 and the rendering of frames of video using the captured image data. The video encoder 114 is similarly non-transitory machine readable instructions that direct the processor to encode frames of video rendered by the image processing pipeline application for storage as encoded video 116 in the memory 108.

Processors 108 in accordance with many embodiments of the invention can be implemented using a microprocessor, a coprocessor, an application specific integrated circuit and/or an appropriately configured field programmable gate array that is directed using appropriate software to take the image data captured by the cameras within the array camera module 102 and output an encoded high frame rate video sequence. In several embodiments, the video sequence is rendered from a reference viewpoint, typically that of a reference camera 104 within the array camera module 102. In many embodiments, the processor is able to synthesize the video sequence from one or more virtual viewpoints, which do not correspond to the viewpoints of any of the focal planes 104 in the array camera module 102. Unless all of the objects within a captured scene are a significant distance from the array camera, the images of the scene captured within the image data will include disparity due to the different fields of view of the cameras used to capture the images. Processes for detecting and correcting for disparity are discussed further below. Although specific array camera architectures are discussed above with reference to FIG. 1, alternative architectures can also be utilized in accordance with embodiments of the invention.

Array Camera Modules

Array camera modules in accordance with embodiments of the invention can be constructed from an imager array or sensor including an array of focal planes and an optic array including a lens stack for each focal plane in the imager array. Sensors including multiple focal planes and the operation of such sensors are discussed in U.S. Patent Publication No. 2012/0013748 entitled "Architectures for System on Chip Array Cameras", to Pain et al. A sensor including a single array of pixels on which images are formed by the optics of each camera can also be utilized to capture image data. In several embodiments, each camera includes a separate sensor. In many embodiments, individual lens barrels are utilized to implement the optics of the camera. Array camera modules incorporating cameras implemented using combinations of separate sensors and optic arrays, separate sensors and separate lens barrels and a single sensor and separate lens barrels in accordance with embodiments of the invention are disclosed in U.S. Patent Application Serial No. 14/536,554 entitled "Array Cameras Incorporating Independently Aligned Lens Stacks" to Rodda et al. filed November 7, 2014. Light filters can be used within each optical channel formed by the optics of a camera in the array camera module to enable different cameras to capture image data with respect to different portions of the electromagnetic spectrum.

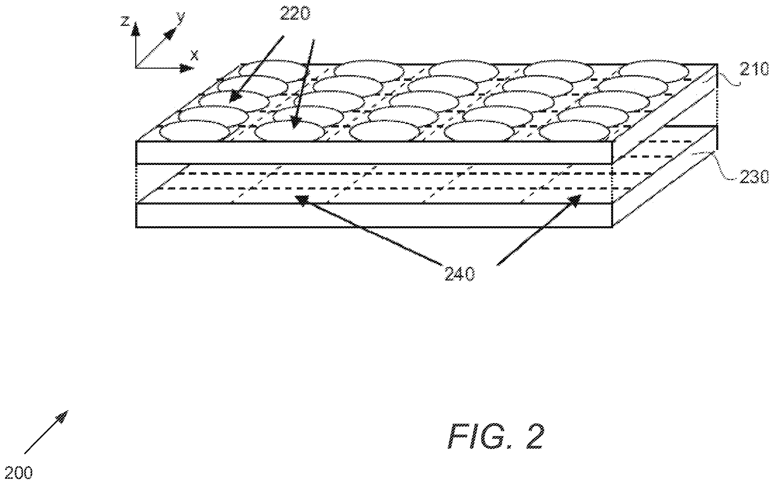

An array camera module implemented using an optic array including a lens stack for each focal plane on a monolithic imager array in accordance with an embodiment of the invention is illustrated in FIG. 2. The array camera module 200 includes an imager array 230 including an array of focal planes 240 along with a corresponding optic array 210 including an array of lens stacks 220. Within the array of lens stacks, each lens stack 220 creates an optical channel that forms an image of the scene on an array of light sensitive pixels within a corresponding focal plane 240. Each pairing of a lens stack 220 and focal plane 240 forms a single camera 104 within the camera module. Each pixel within a focal plane 240 of a camera 104 generates image data that can be sent from the camera 104 to the processor 108. In many embodiments, the lens stack within each optical channel is configured so that pixels of each focal plane 240 sample the same object space or region within the scene. In several embodiments, the lens stacks are configured so that the pixels that sample the same object space do so with sub-pixel offsets to provide sampling diversity that can be utilized to recover increased resolution through the use of super-resolution processes. In this way, the same array of cameras can offer increased resolution during single frame image capture and support high frame rate video capture.

In the embodiment illustrated in FIG. 2, the focal planes are configured in a 5 x 5 array. Each focal plane 240 on the sensor is capable of capturing an image of the scene. Typically, each focal plane includes a plurality of rows of pixels that also forms a plurality of columns of pixels, and each focal plane is contained within a region of the imager that does not contain pixels from another focal plane. In many embodiments, image data capture and readout of each focal plane can be independently controlled. In this way, image capture settings including (but not limited to) the exposure times and analog gains of pixels within a focal plane can be determined independently to enable image capture settings to be tailored based upon factors including (but not limited to) a specific color channel and/or a specific portion of the scene dynamic range. The sensor elements utilized in the focal planes can be individual light sensing elements such as, but not limited to, traditional CIS (CMOS Image Sensor) pixels, CCD (charge-coupled device) pixels, high dynamic range sensor elements, multispectral sensor elements and/or any other structure configured to generate an electrical signal indicative of light incident on the structure. In many embodiments, the sensor elements of each focal plane have similar physical properties and receive light via the same optical channel and color filter (where present). In other embodiments, the sensor elements have different characteristics and, in many instances, the characteristics of the sensor elements are related to the color filter applied to each sensor element.

In several embodiments, color filters in individual cameras can be used to pattern the camera module with $\pi$ filter groups as further discussed in U.S. Patent Publication No. 2014/0293760 entitled "Camera Modules Patterned with pi Filter Groups" to Nisenzon et al. These cameras can be used to capture data with respect to different colors, or a specific portion of the spectrum. In contrast to applying color filters to the pixels of the camera, color filters in many embodiments of the invention can be included in the lens stack and/or elsewhere within an optical channel. For example, a Green color camera can include a lens stack with a Green light filter that allows Green light to pass through the optical channel. In many embodiments, the pixels in each focal plane are the same and the light information captured by the pixels is differentiated by the color filters in the corresponding lens stack for each filter plane. Although a specific construction of a camera module with an optic array including color filters in the lens stacks is described above, camera modules including $\pi$ filter groups can be implemented in a variety of ways including (but not limited to) by applying color filters to the pixels of the focal planes of the camera module similar to the manner in which color filters are applied to the pixels of a conventional color camera. In several embodiments, at least one of the cameras in the camera module can include uniform color filters applied to the pixels in its focal plane. In many embodiments, a Bayer filter pattern is applied to the pixels of at least one of the cameras in a camera module. In a number of embodiments, camera modules are constructed in which color filters are utilized in both the lens stacks and on the pixels of the imager array.

Although specific array cameras and imager arrays are discussed above, many different array cameras can be utilized to capture image data and synthesize images using restricted depth of field depth maps as appropriate to the requirements of specific applications in accordance with embodiments of the invention. Imager arrays in accordance with various embodiments of the invention are discussed further below.

Capturing Image Data with Groups of Active Cameras

Cameras in an array camera module in accordance with many embodiments of the invention can be grouped into subsets or groups for capturing image data. The manner in which high speed video sequences are rendered and depth maps are generated depends upon the number and type of cameras in each group. Various techniques for estimating depth and rendering frames of video at high frame rates based upon the number, type and/or layout of the groups of cameras in an array are described further below. In a number of embodiments, the cameras in the array capture image data in a single color channel. In several embodiments, the cameras in an array can incorporate spectral filters patterned to enable one or more of the cameras to capture image data in multiple color channels (e.g. Bayer filter patterns). In a number of embodiments, various cameras in an array have different spectral filters so that the cameras capture image data in a single color channel and the combined image data yields a set of image data captured in multiple color channels.

In embodiments in which individual cameras image in all of the color channels of the array camera, high frame rate video can be rendered using groups of cameras that include one or more cameras. In embodiments in which different cameras capture images in different color channels, the groups of cameras typically include at least one camera from each color channel. In embodiments in which only one camera from a given color channel is included in a group of cameras, then depth estimation can be performed using image data captured by multiple different groups of cameras. Where a group includes multiple cameras from at least one color channel, then depth estimation can be performed using only the image data captured by cameras in the group. Although, for a variety of reasons an array camera may still utilize image data captured by multiple groups of cameras to perform depth estimation.

In many embodiments, groups of cameras that each include a 3 x 3 $\pi$ filter group incorporating Red, Green and Blue cameras are used to capture image data from which frames of video can be synthesized at a frame rate that is higher than the rolling shutter speed for the 3 x 3 $\pi$ filter group of cameras. Image data captured by multiple different $\pi$ filter groups of cameras during successive frame capture time intervals can be utilized to render video at a frame rate that is faster than the rolling shutter speed of an individual 3 x 3 $\pi$ filter group of cameras. Image data captured by a single 3 x 3 $\pi$ filter groups of cameras can be used to estimate depth for pixels imaged by the 3 x 3 $\pi$ filter groups of cameras using the techniques described in U.S. Patent 8,619,082 and U.S. Patent Publication No. 2014/0267243. The estimated depths can then be used to shift pixels, such as (but not limited to) moving pixels, into the viewpoint of a reference camera within one of the 3 x 3 $\pi$ filter groups of cameras. In other embodiments, any of a variety of groups of cameras can be utilized that enable depth to be estimated from the image data captured by an individual group of cameras during the rendering of high frame rate video sequences.

As can readily be appreciated, utilizing 3 x 3 $\pi$ filter groups of cameras to capture image data may necessitate a large array of cameras. By way of example, an array camera using 3 x 3 $\pi$ filter groups of cameras that have a rolling shutter enabling readout at 30 fps can require at least a 6 x 6 array of cameras in order to render video at a rate of 120 fps. A similar frame rate can be achieved in accordance with many embodiments of the invention by utilizing smaller groups of cameras. In several embodiments, each group of cameras includes a single Red, Green, and Blue camera.

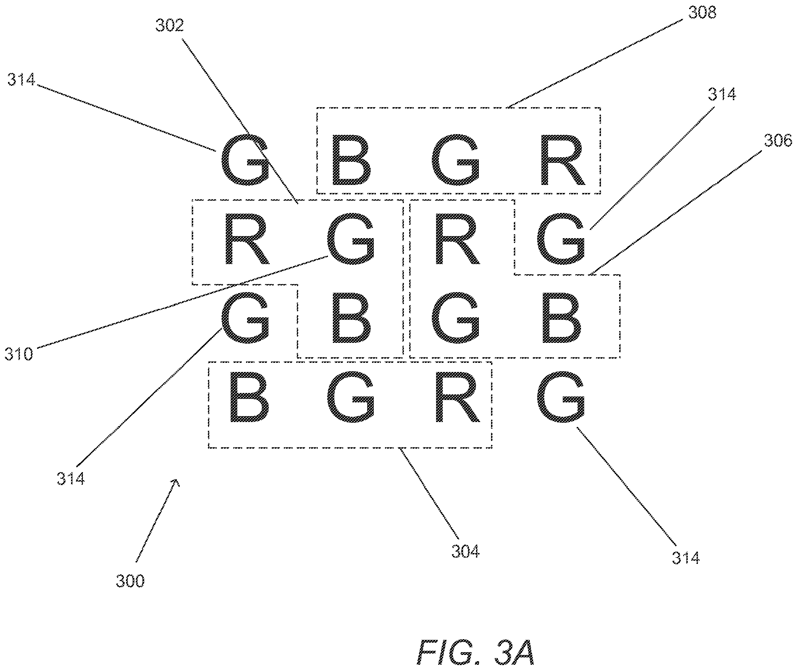

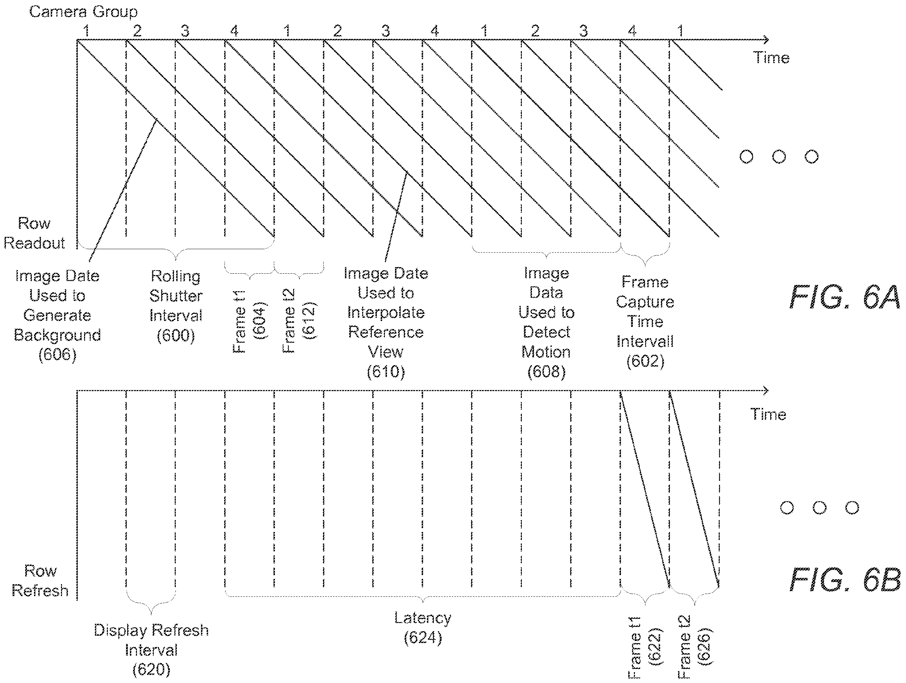

A 4 x 4 array camera module including four groups of active cameras configured to capture image data used to render a high speed video sequence from the viewpoint of a reference camera in accordance with an embodiment of the invention is illustrated in FIG. 3A. The 4 x 4 array camera module 300 is used to define four groups of cameras that each includes a single Blue camera, a single Green camera, and a single Red camera. In order to reduce the largest shift between viewpoints of cameras in a given time interval, a first group 302 is read out starting at a first capture time, a second group 304 is read out starting at a staggered second capture time, a third group 306 is read out starting at a further staggered third capture time, and a fourth group 308 is read out starting at a still further staggered fourth capture time. As is discussed further below with reference to FIGS. 6A - 6E, the staggering of the start of the capture times of the different groups of cameras and the fact that the frame rate is faster than the rolling shutter of each group of cameras means that each camera captures and reads out image data from at least 1/N of the total number of rows (or columns) of a rendered frame during each frame capture time interval, where N is the number of groups of cameras (i.e. ¼ of the total number of rows in the rendered frame for the illustrated embodiment). The image data captured by the cameras can be photometrically and geometrically normalized to increase the similarity of the imaged data captured by each of the cameras. These (and other) normalization processes can improve the accuracy of depth estimates generated by the array camera. The process of estimating the depth to objects within the scene can involve determining scene geometric corrections that can be applied to shift pixels captured from different viewpoints into a reference viewpoint. Computational complexity can be reduced by only estimating depth for moving pixels, and then using the depth estimates to shift the moving pixels to the reference viewpoint. Alternatively, systems can assume that motion is uniform and determine motion between two viewpoints and utilize the motion vectors for the moving pixels with respect to other viewpoints. Once the moving pixels are shifted into the reference viewpoint, a new frame from the reference viewpoint can be rendered by compositing the moving pixels with non-moving pixels from a frame previously rendered from the reference viewpoint.

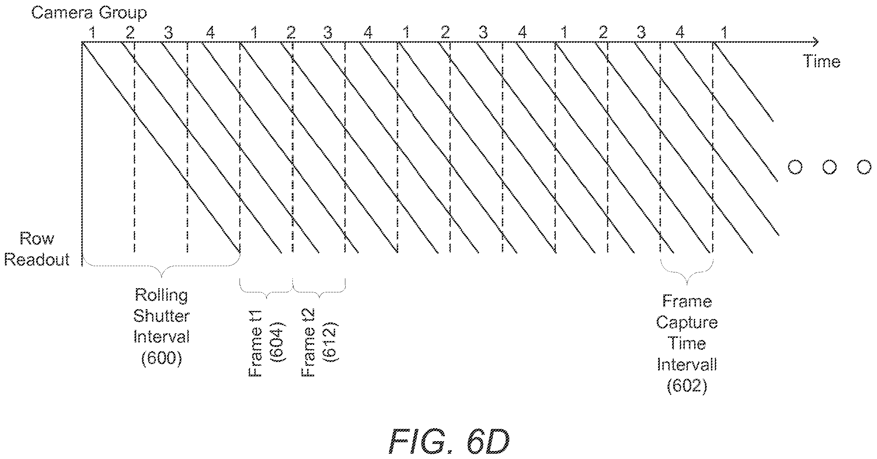

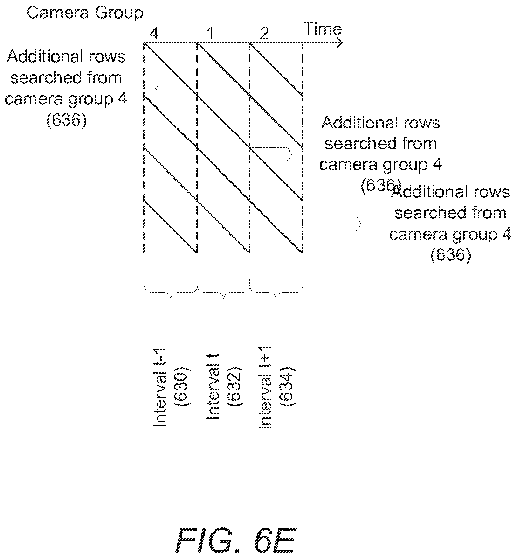

In many embodiments, more than 1/N of the total number of rows (or columns) of a rendered frame are read out from each of N groups of cameras during a frame capture time interval to accommodate vertical parallax observable between the viewpoints of the cameras in the different groups of cameras. Conceivably, pixels that are not visible in a first set of rows read out from a first group of cameras may also not be visible in a second sequential group of rows read out from a second group of cameras due to vertical parallax shifting the unobserved pixels into the field of view sampled by the first 1/N of the total number rows (or columns) of the sensors in the second group of cameras. By increasing the number of rows (or columns) read out during a frame capture time interval by an amount corresponding to the likely observed vertical parallax of foreground objects between viewpoints of groups of cameras that sample progressive portions of the scene, then the likelihood of unobserved objects or portions of objects at the boundaries between portions of the scene sampled by different groups of cameras during a display frame interval can be diminished. Readout of approximately 1/3rd of the rows of four groups of cameras during every frame capture interval is conceptually illustrated in FIG. 6D. As can readily be appreciated, there is overlap in the sequential groups of rows captured by each of the groups of cameras enabling identification of objects that might otherwise be unobserved due to vertical parallax. Alternatively, searches can be conducted with respect to image data captured by the camera during the previous or next frame capture time interval. The searching of additional rows captured by a specific camera group during a previous frame capture interval (630) to the frame capture interval of a rendered frame (632) and/or a subsequent frame capture time interval (634) is conceptually illustrated in FIG. 6E. Objects that might otherwise be unobserved due to vertical parallax can be rendered by searching for the objects in additional rows captured by a camera group during different frame capture intervals. Viewed another way, the frame capture time intervals could be considered to overlap in the sense that certain rows (or columns) of image data captured by a camera could be used in the rendering of two successive frames in the high speed video sequence in order to accommodate vertical parallax at the boundaries between the portions of a rendered frame captured by different groups of cameras in a manner that is conceptually similar to the readout of more than 1/N of the total number of rows (or columns) of the rendered frame.

As noted above, depth estimation can be simplified by including multiple cameras within a color channel in each group of cameras. Accordingly, the groups of cameras illustrated in FIG. 3A can be increased in size to accommodate a second Green camera 314 to provide additional image data in the Green color channel for use in depth estimation. Typically, pairs of Green cameras with large baselines are combined within a subgroup to increase observed disparity between the images captured by the Green cameras. Increasing the number of cameras can increase the rolling shutter time to acquire data from a group of cameras, thereby incorporating a second Green camera in each group of cameras can result in a drop in the display frame rate of the high speed video.

As is discussed further below, depth can be estimated without requiring that a group of cameras incorporate multiple cameras within a color channel. In many embodiments, depth for non-moving pixels can be estimated utilizing image data captured by multiple groups of cameras over one or more rolling shutter intervals. In several embodiments, moving pixels are identified using sequential sets of image data captured by each of the groups of cameras. The moving pixels are then disregarded and the images captured during one or more rolling shutter intervals by the active cameras in the array can be utilized to perform depth estimation with respect to the non-moving pixels. Depth estimation for moving pixels during a given frame capture time interval can be determined by interpolating a frame or a portion of a frame from an alternate viewpoint in at least one color channel (typically a Green color channel) for the relevant frame capture time interval for the purpose of performing parallax detection. In many embodiments, frames or portions of frames are interpolated from alternate viewpoints in each of the Red, Green and Blue color channels and disparity searches are conducted with respect to the image data captured in the Green, Red and Blue color channels. In a number of embodiments, image gradient can be utilized to compare similarity of corresponding images captured in different color channels reducing the need to provide multiple cameras of the same color channel to perform disparity estimation.

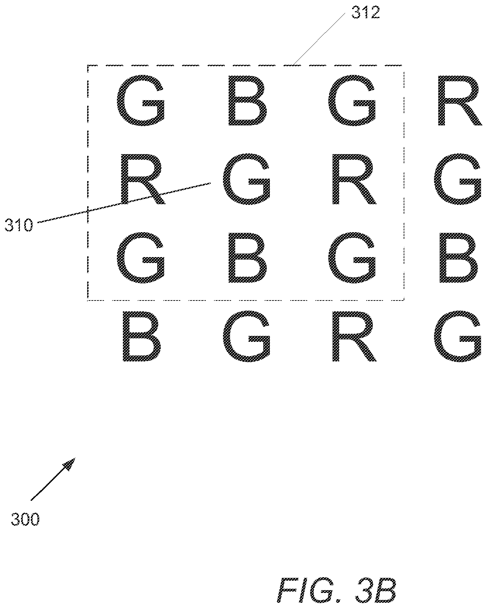

As noted above, different processes for estimating depth can be used for moving and non-moving pixels. Due to the static nature of non-moving pixels, depth estimation for non-moving pixels can be performed using image data captured over periods of time longer than the frame capture time interval. Furthermore, the frequency with which depth estimates need to be made with respect to non-moving pixels is sufficiently low that different groupings of cameras can be used to capture image data for estimating the depth of non-moving pixels. In several embodiments, an initial group of cameras including multiple cameras in at least one of the color channels is used to generate an initial depth map and then smaller groups of cameras are used to acquire image data for rendering high frame rate video sequences. As discussed above, the initial depth map can be used to seed depths for non-moving pixels and seed and/or constrain subsequent depth searches for moving pixels. In a number of embodiments, computation can be reduced by assuming that depth, once determined, remains constant over a short time interval corresponding to a number of successive frames. A 4 x 4 array camera module including a 3 x 3 $\pi$ filter group of cameras configured to capture image data from which an initial depth map can be estimated in accordance with an embodiment of the invention is illustrated in FIG. 3B. The 4 x 4 array camera module 300 includes an initial group 312 of 3 x 3 active cameras patterned using a $\pi$ filter group and utilized to capture image data that can be utilized to synthesize color images and/or video sequences. In the illustrated embodiment, a $\pi$ filter group includes a Green camera at each corner, a Green reference camera in the center 310, Blue cameras above and below the reference camera, and Red cameras to the left and right sides of the reference camera. In several embodiments, the locations of the Red and Blue cameras within the $\pi$ filter group are swapped and/or an alternative collection of cameras can be utilized to capture image data to synthesize images. In several embodiments, a camera that captures white light, a camera that captures infrared light or a Bayer camera can be utilized at the center of the 3 x 3 $\pi$ filter group of cameras. In various embodiments, a second subset 306 of active cameras includes a row of Blue, Green, and Red cameras placed below the $\pi$ filter group and a column of Blue, Green, and Red cameras placed to the right side of the $\pi$ filter group with a Green camera connecting the row and the column. In various embodiments, the second subset of active cameras is configured to capture image data for measuring scene information as is described in U.S. Patent Application Serial No. 61/775,395 entitled "Systems and Methods for Measuring Scene Information While Capturing Images Using Array Cameras" filed March 8, 2013.

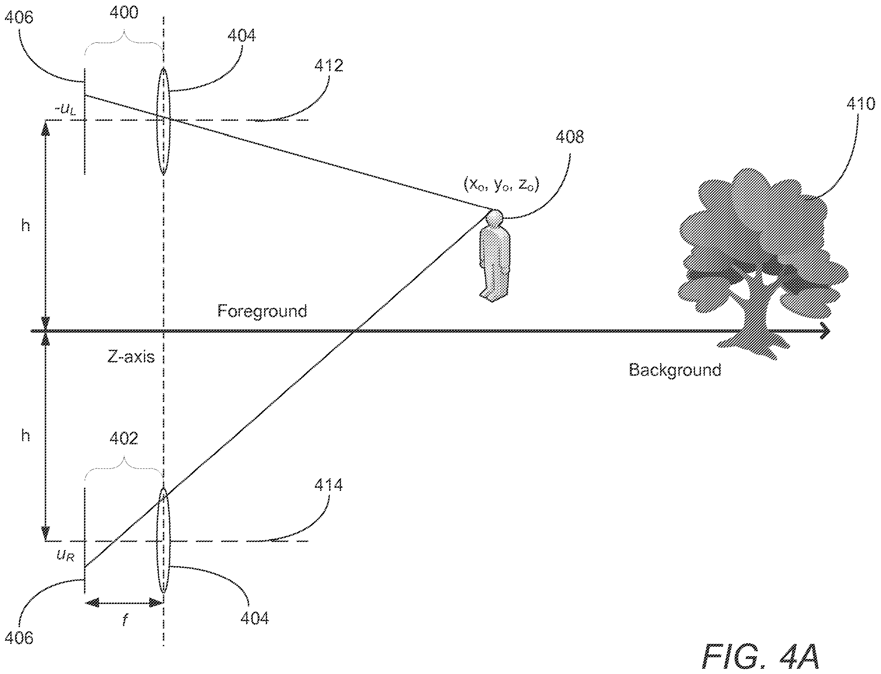

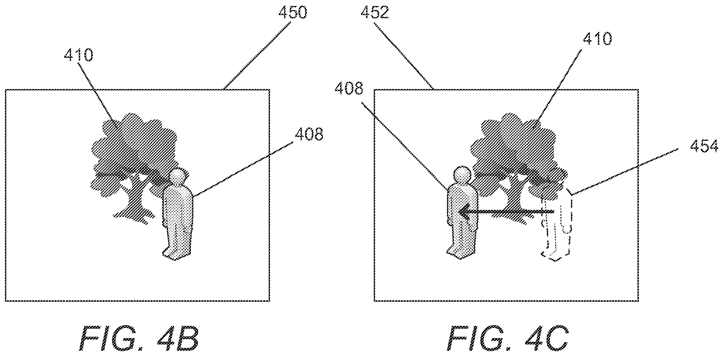

Although specific groups of cameras utilized to capture image data are described above with reference to FIGS. 4A and 4B, the specific groups of cameras utilized can depend upon the type and number of cameras present in an array camera, the rolling shutter speed of image data readout by the array camera, the desired frame rate and the requirements of a specific application. Processes for rendering high speed video sequences using image data captured using groups of cameras within an array camera in accordance with embodiments of the invention are discussed further below. Before discussing these processes, however, a brief review of the scene dependent geometric shifts or parallax observed in image data captured by cameras from different viewpoints is provided below. As can readily be appreciated by the discussion above, accurate estimation of the scene dependent geometric shifts that are present in the image data captured by different groups of cameras from different viewpoints can be an important factor in the rendering of smooth high speed video.

Determining Parallax/Disparity

In a number of embodiments, individual cameras in an array used to capture image data have similar fields of view, fixed apertures, and focal lengths. Parallax in a two camera system is illustrated in FIG. 4A. The two cameras 400, 402, include a lens stack 404 and a focal plane 406. Each camera has a back focal length f, and the two cameras are separated by the baseline distance of *2h*. The field of view of both cameras encompasses a scene including a foreground object 408 and a background object 410. The scene from the viewpoint of the first camera 400 is illustrated in FIG. 4B. In the image 450 captured by the first camera, the foreground object 408 appears located slightly to the right of the background object 410. The scene from the viewpoint of the second camera 402 is illustrated in FIG. 4C. In the image 452 captured by the second camera, the foreground object 408 appears shifted to the left hand side of the background object 410. The disparity introduced by the different fields of view of the two cameras 400, 402, is equal to the difference in location of the foreground object 408 between its location in the image captured by the first camera (indicated in the image captured by the second camera by ghost lines 454) and its location in the image captured by the second camera. As is discussed further below, the distance from the two cameras to the foreground object can be obtained by determining the disparity of the foreground object in the two captured images.

Referring again to FIG. 4A, the point $(x_o, y_o, z_o)$ on the foreground object will appear on the focal plane of each camera at an offset from the camera's optical axis. The offset of the point on the focal plane of the first camera 400 relative to its optical axis 412 is shown as $-u_L$. The offset of the point on the focal plane of the second camera 402 relative to its optical axis 414 is shown as $u_R$. Using similar triangles, the offset between the images captured by the two cameras can be observed as follows:

$$\frac{h - x_o}{z_o} = \frac{-u_L}{f}$$

$$\frac{h + x_o}{z_o} = \frac{u_R}{f}$$

$$\frac{h - x_o}{z_o} = \frac{-u_L}{f}$$

$$\frac{h + x_o}{z_o} = \frac{u_R}{f}$$

Combining the two equations yields the disparity (or parallax) between the two cameras as:

$$\Delta_{parallax} = u_R - u_L = \frac{2hf}{z_o}$$

From the above equation, it can be seen that disparity between images captured by the cameras is along a vector in the direction of the baseline of the two cameras, which can be referred to as the epipolar line between the two cameras. Furthermore, the magnitude of the disparity is directly proportional to the baseline separation of the two cameras and the back focal length of the cameras and is inversely proportional to the distance from the camera to an object appearing in the scene.

Occlusions In Array Cameras

When multiple images of a scene are captured from different perspectives and the scene includes foreground objects, the disparity in the location of the foreground object in each of the images results in portions of the scene behind the foreground object being visible in some but not all of the images. A pixel that captures image data concerning a portion of a scene, which is not visible in images captured of the scene from other viewpoints, can be referred to as an occluded pixel. Referring again to FIGS. 4B and 4C, when the viewpoint of the second camera is selected as a reference viewpoint the pixels contained within the ghost lines 454 in the image 452 can be considered to be occluded pixels (i.e. the pixels capture image data from a portion of the scene that is visible in the image 452 captured by the second camera 402 and is not visible in the image 450 captured by the first camera 400). In the second image, the pixels of the foreground object 408 can be referred to as occluding pixels as they capture portions of the scene that occlude the pixels contained within the ghost lines 454 in the image 452. Due to the occlusion of the pixels contained within the ghost lines 454 in the second image 452, the distance from the camera to portions of the scene visible within the ghost lines 454 cannot be determined from the two images as there are no corresponding pixels in the image 450 shown in FIG. 4B.

As is discussed further below, increasing the number of cameras capturing images of a scene from different viewpoints in complimentary occlusion zones around the reference viewpoint increases the likelihood that every portion of the scene visible from the reference viewpoint is also visible from the viewpoint of at least one of the other cameras. When the array camera uses different cameras to capture different wavelengths of light (e.g. RGB), distributing at least one camera that captures each wavelength of light on either side of the reference viewpoint, and/or in the quadrants surrounding a reference viewpoint can significantly decrease the likelihood that a portion of the scene visible from the reference viewpoint will be occluded in every other image captured within a specific color channel. Accordingly, more reliable depth estimates can be obtained for non-moving pixels by performing parallax detection with respect to non-moving pixels over all image data captured during a single rolling shutter interval by the active cameras in an array camera. In this way, the images captured in each color channel within complementary occlusion zones can be utilized in the estimation of depth for the non-moving pixels. The distribution of color filters in array cameras to reduce the likelihood of occlusions in accordance with embodiments of the invention is discussed further in U.S. Patent Publication No. 2014/0293760. Where depth estimates for moving pixels cannot be made using image data captured from within complementary occlusion zones (e.g. when each group only contains a single camera in each color channel), the effects of occlusion can be minimized by filtering depth estimates for moving pixels across rendered frames. In this way, obvious depth discontinuities arising from occlusions can be smoothed and/or ignored to increase the likelihood that depth is estimated correctly.

Using Disparity To Generate Depth Estimates in Array Cameras

Array cameras in accordance with many embodiments of the invention use disparity observed in images captured by the array cameras to estimate depth and/or generate a depth map. A depth map is typically regarded as being a layer of meta-data concerning an image or frame of video that describes the distance from the camera to specific pixels or groups of pixels within the image (depending upon the resolution of the depth map relative to the resolution of the image). Array cameras in accordance with a number of embodiments of the invention use depth maps for a variety of purposes including (but not limited to) generating scene dependent geometric shifts during the synthesis of a high resolution image and/or rendering of high frame rate video sequences.

Based upon the discussion of disparity above, the process of determining the depth of a portion of a scene based upon pixel disparity is theoretically straightforward. When the viewpoint of a specific camera in the array camera is chosen as a reference viewpoint, the distance to a portion of the scene visible from the reference viewpoint can be determined using the disparity between the corresponding pixels in some or all of the images captured by the camera array. In the absence of occlusions, a pixel corresponding to a pixel in the image captured from the reference viewpoint will be located in each image along an epipolar line (i.e. a line parallel to the baseline vector between the two cameras). The distance along the epipolar line of the disparity corresponds to the distance between the camera and the portion of the scene captured by the pixels. Therefore, by comparing the pixels in the captured images that are expected to correspond at a specific depth, a search can be conducted for the depth that yields the pixels having the highest degree of similarity. The depth at which the corresponding pixels in the captured images have the highest degree of similarity can be assumed to be the most likely distance between the camera and the portion of the scene captured by the pixel. Similar processes can be utilized when synthesizing a depth map from a virtual viewpoint.

Many challenges exist, however, in determining an accurate depth estimates using the method outlined above. In several embodiments, the cameras in an array camera are similar but not the same. Therefore, characteristics including (but not limited to) optical characteristics, different sensor characteristics (such as variations in sensor response due to offsets, different transmission or gain responses, non-linear characteristics of pixel response), noise in the captured images, and/or warps or distortions related to manufacturing tolerances related to the assembly process can vary between the images reducing the similarity of corresponding pixels in different images. In addition, super-resolution processes rely on sampling diversity and/or aliasing in the images captured by an imager array in order to synthesize higher resolution images. However, increasing sampling diversity can also involve decreasing similarity between corresponding pixels in the images captured by an array camera. Given that the process for determining depth outlined above relies upon the similarity of pixels, the presence of photometric differences and sampling diversity between the captured images can reduce the accuracy with which a depth map can be determined.

The generation of depth estimates can be further complicated by occlusions. As discussed above, an occlusion occurs when a pixel that is visible from the reference viewpoint is not visible in one or more of the captured images. The effect of an occlusion is that at the correct depth, the pixel location that would otherwise be occupied by a corresponding pixel is occupied by a pixel capturing another portion of the scene (typically an object closer to the camera). The occluding pixel is likely very different to the occluded pixel. Therefore, a comparison of the similarity of the pixels at the correct depth is less likely to result in a significantly higher degree of similarity than at other depths. Effectively, the occluding pixel acts as a strong outlier masking the similarity of those pixels, which correspond. Accordingly, the presence of occlusions can introduce a strong source of error into a depth map and processes for determining depth maps such as those disclosed in U.S. Patent 8,619,082 and U.S. Patent Publication No. 2014/0267243 involve detecting occlusions and determining depths using non-occluded pixels. Systems and methods for generating depth estimates for the use in rendering high frame rate video sequences in accordance with embodiments of the invention are discussed further below.

Processes for Rendering High Frame Rate Video Sequences

Processes for rendering of high frame rate video sequences in accordance with various embodiments of the invention typically vary based upon the availability of depth information. As discussed above, processes in accordance with many embodiments of the invention involve detecting moving pixels in image data captured from different viewpoints and shifting moving pixels captured from alternate viewpoints to a reference viewpoint. The moving pixels can then be composited with non-moving pixels from a previously rendered frame. In array cameras where depth information can be synthesized using cameras within a group of cameras, the process of shifting moving pixels is relatively straightforward and the processes described in U.S. Patent 8,619,082 and U.S. Patent Publication No. 2014/0267243 can be utilized to perform parallax detection and to assign confidence metrics to the depth estimates. In other embodiments, image data captured by multiple groups of cameras over different time intervals is utilized to determine scene-dependent geometric corrections to shift image data captured from alternate viewpoints to the reference viewpoint.

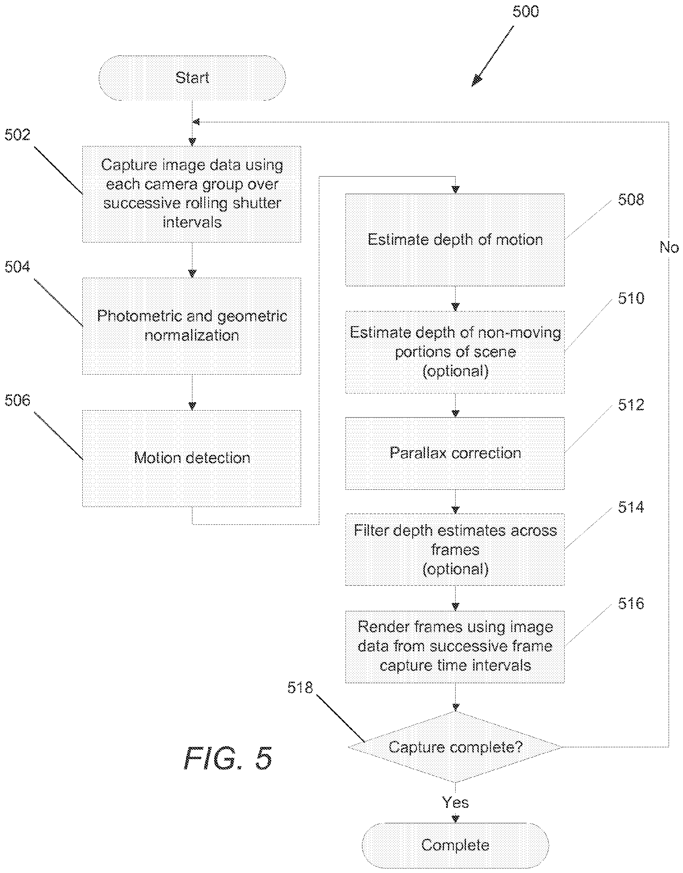

A process for rendering a video sequence using image data captured by groups of cameras in an array in accordance with an embodiment of the invention is illustrated in FIG. 5. The process 500 includes capturing (502) image data using each group of cameras over successive rolling shutter time intervals, where the start time of the capture of image data in each camera group is staggered so that each of the cameras in the N camera groups captures at least 1/N of the total rows (or columns) of a rendered frame are capable of being captured by the camera during a frame capture time interval. As noted above, the rolling shutter time interval is typically significantly longer than the frame capture time interval. Image data is captured over successive rolling shutter intervals to enable the detection of motion using sequential sets of image data captured by each active camera. The staggering of the start times of the capture of image data by the groups of cameras results in the combined image data captured by the groups of cameras during each frame capture time interval being sufficient to render a complete frame of video at the frame rate of the high speed video sequence.

Photometric and geometric normalization is performed (504) using calibration data to increase the similarity of the images captured by different cameras. As noted above, increasing the similarity of the image data can facilitate disparity searches. Photometric and geometric normalization processes similar to those disclosed in U.S. Patent Publication No. 2012/0147205 entitled "Systems and Methods for Synthesizing High Resolution Images Using Super-Resolution Processes" to Lelescu et al. and U.S. Patent 8,619,082.

In many embodiments, motion detection is performed (506). Motion detection within the portion of a frame captured by a given camera during a frame capture time interval is typically performed using image data captured by the same camera during a different frame capture time interval (as opposed to through comparison with image data captured by a different camera). Utilizing the same viewpoint can simplify motion detection. Motion detection can be performed by simply looking for pixels with intensities that differ by a threshold amount. The threshold can be based upon the local signal to noise ratio, localized statistics with respect to the sequence of portions of frames, and/or a predetermined threshold number. As can readily be appreciated, any of a variety of techniques can be utilized to detect motion as appropriate to the requirements of specific applications in accordance with embodiments of the invention.

In several embodiments, depth estimates are generated (508) for the moving pixels. As noted above, depth estimates can be obtained using image data captured by a single group of cameras during a frame capture time interval, where the single group of cameras includes at least two cameras that capture image data in the same color channel. In a number of embodiments, depth estimates with respect to moving pixels captured from a first viewpoint during a given frame capture time interval by interpolating at least a portion of a frame in which the same portion of the scene is visible from a second viewpoint at the frame capture time interval and performing disparity searches with respect to the moving pixels. In several embodiments, disparity searches are performed with respect to individual moving pixels, clusters of moving pixels, and/or all moving pixels. Processes for interpolating frames and conducting disparity searches in accordance with various embodiments of the invention are discussed further below.

In several embodiments, depth is also estimated (510) for non-moving pixels in the scene. Typically, the depth estimates for non-moving pixels are propagated from a previous depth estimate. The fact that the pixels are non-moving means that the depth of the pixel remains unchanged from at least one rolling shutter time interval to the next. An initial depth estimate for non-moving pixels can be determined by capturing an initial set of image data and estimating depth using the techniques disclosed in U.S. Patent 8,619,082. Confidence metrics can also be assigned to the depth estimates using any of the techniques disclosed in U.S. Patent 8,619,082. As can readily be appreciated, a larger group of cameras can also be used to capture the initial set of image data over a single rolling shutter time interval, such as (but not limited to) the 3 x 3 $\pi$ filter group of cameras shown in FIG. 3B. In other embodiments, any of a variety of groups of cameras can be utilized in the capture of an initial depth map of a scene as appropriate to the requirements of specific applications. In many embodiments, the image data captured by all of the active cameras in all of the groups of cameras over at least one rolling shutter time interval can be utilized to estimate the depth of non-moving pixels. The more viewpoints available during depth estimation, the more robust the depth estimation process can be to occlusions. Where depth is estimated based upon aggregation of image data from multiple groups of cameras, the depth estimates for the non-moving pixels can be made from the same image data used to render multiple frames of high frame rate video (as opposed to capturing image data for an initial frame and then commencing capture of image data for rendering subsequent frames of the high frame rate video sequence).

The depth estimates for the moving and non-moving pixels can be utilized to perform (512) parallax correction. The parallax correction applies scene-dependent geometric corrections to the pixels captured by each of the active cameras from alternate viewpoints to shift the pixels to a reference viewpoint. The specific shift is determined based upon the observed disparity between the alternate viewpoint and the reference viewpoint and the baseline between the alternate viewpoint and the reference viewpoint. In several embodiments, the depth estimates are (optionally) filtered (514) based upon depth estimates for moving pixels in previous and/or successive frames. In this way, the impact of errors resulting from the depth estimation process can be reduced by restricting object depth changes in a way that is consistent with the manner in which objects move in the real world. As can readily be appreciated, the application of filtering to depth estimates is typically dependent upon the requirements of specific applications.

In a number of embodiments, frames of video are rendered (516) using image data captured by the array of cameras during each frame capture time interval. In several embodiments, the rendering process involves rendering an initial frame from a reference viewpoint and then rendering subsequent frames by compositing moving pixels observed by the cameras in the array, shifted to the reference viewpoint where necessary, with the non-moving pixels observed by the cameras in the array camera.

In array cameras where the reference camera is capable of capturing image data in each color channel supported by the array camera, then the process of rendering an initial frame from a reference viewpoint is straightforward. The reference camera simply captures a complete frame of image data. In array cameras in which different cameras capture image data in the different color channels supported by the array camera, then an initial frame can be rendered using image data captured by an initial group of cameras. A reference viewpoint can be selected with respect to the viewpoints of the cameras in the initial group of cameras and then a dense depth map determined with respect to the reference viewpoint using any of the techniques described above including (but not limited to) performing disparity searches using image data captured by the initial group of cameras, and/or performing disparity searches using image data captured by the initial group of cameras and one or more additional groups of cameras. A dense depth map can be utilized to render an initial frame by fusing images captured in different color channels from alternate viewpoints into the reference viewpoint. In several embodiments, the initial fusion accounts for the confidence of the depth estimates and information concerning the visibility from the reference viewpoint of specific pixels visible from an alternate viewpoint. Processes that can be utilized to fuse pixels from different color channels include (but are not limited to) the fusion processes disclosed in U.S. Patent Publication No. 2012/0147205. As can readily be appreciated, any of a variety of processes can be utilized to render an initial frame for a high speed video sequence appropriate to the requirements of specific applications in accordance with embodiments of the invention.

The process described above repeats during each frame capture time interval until a determination (518) is made that the capture of image data and rendering of video frames is complete. Periodically, the process can render a new initial frame to ensure that artifacts such as (but not limited to) artifacts due to depth estimation errors do not propagate throughout the entire video sequence. In several embodiments, the firing pattern of the cameras can be modified as part of the process of rendering a new initial frame. In many embodiments, all cameras can be fired simultaneously to capture a new initial frame and then staggered for rendering of subsequent frames. The manner in which firing patterns are modified during the capture of a high speed video sequence typically depends upon the capabilities of a specific camera array and the requirements of a particular application.

Image Data Capture Sequence

The manner in which different groups of cameras in an array camera can capture image data and the image data utilized to render frames of video can be understood with reference to the timing diagrams illustrated in FIGS. 6A - 6C. A timing diagram showing the capture and readout of rows of image data by groups of cameras in an array camera during high speed video capture is illustrated in FIG. 6A. Time is illustrated on the x-axis and row readout is illustrated on the y-axis. In the illustrated example, the cameras in the groups of cameras have rolling shutters and so the readout of rows is represented as a diagonal line. The time taken for a single group of cameras to read out all of the rows of image data is indicated as the rolling shutter interval 600. The vertical dashed lines correspond to the frame capture time interval 602, which is equal to the inverse of the target high-speed frame rate (i.e. the display refresh interval 620 shown in FIG. 6B). In the example illustrated in FIG. 6A, the first group of cameras captures a still frame that is used to render non-moving pixels a high speed video sequence. Each frame of the high speed video sequence is rendered using the non-moving pixels in combination with moving pixels detected within image data captured by the four different groups of cameras during the same frame capture time interval. The image data captured by the four groups of cameras (1, 2, 3, 4) during the frame capture time interval for frame t1 (604) is used to render a first frame of video. As noted above, frame capture time intervals can overlap to accommodate vertical parallax between the groups of cameras (not shown).

In order to detect parallax for image data captured by a group of cameras at the frame capture time interval for frame t1 (604), at least one corresponding portion of a frame can be interpolated from one or more different viewpoints at the frame capture time interval for frame t1 (604). When the group of cameras that captured the image data does not include a camera that captures image data from the reference viewpoint, then a frame is typically interpolated at the frame capture time interval for frame t1 (604) from the reference viewpoint. Portions of frames from the reference viewpoint can be interpolated at the frame capture time interval for frame t1 (604) using the image data (606, 610) captured by at least one camera in the first group of cameras from the reference viewpoint over at least two rolling shutter intervals. An interpolated portion of a frame can be utilized to estimate the depth of moving pixels by comparing disparity searches with respect to the moving pixels between the viewpoint of at least one camera in the group of cameras that captured the image data from the alternate viewpoint during the frame capture time interval for frame t1 (604) and the interpolated frame from the reference viewpoint. Where a group of cameras includes cameras that capture image data in different color channels, depth can be estimated for moving pixels observed from the reference viewpoint and in the same color channel as the reference camera using a similar process involving interpolating a portion of a frame from an alternate viewpoint at the frame capture time interval for frame t1 (604). The depths of the moving pixels in the cameras in groups 1, 2, 3, 4 that are captured from alternate viewpoints are then shifted into the reference viewpoint using the depth estimates and composited with the non-moving pixels from a previously rendered frame. A similar process can be utilized to render a second frame from image data captured by the groups of cameras (1, 2, 3, 4) during the capture time for frame t2 (612) and to render subsequent frames.

The rendering of frames from data captured in accordance with the process illustrated in FIG. 6A is conceptually illustrated in FIG. 6B. Time is illustrated on the x-axis and row refresh is illustrated on the y-axis. In the illustrated example, the rows of pixels are progressively refreshed. Therefore, the progressive refreshing of a display during each display refresh interval (620) is conceptually illustrated as a diagonal line. As can readily be appreciated, similar processes could be utilized to render and display interlaced frames of video. Due to the need to detect motion and interpolate frames to estimate depth, there is latency (624) between capturing image data during the capture time of frame t1 (604) and the display time of frame t1. At frame rates such as (but not limited to) 120 fps, however, latency in the order of eleven display refresh intervals from the time at which image data capture commences is imperceptible during video capture (e.g. display of a preview video sequence while capturing video). Once the first frame is rendered, the second frame t2 (626) and subsequent frames can be rendered for display at the high speed video frame rate.

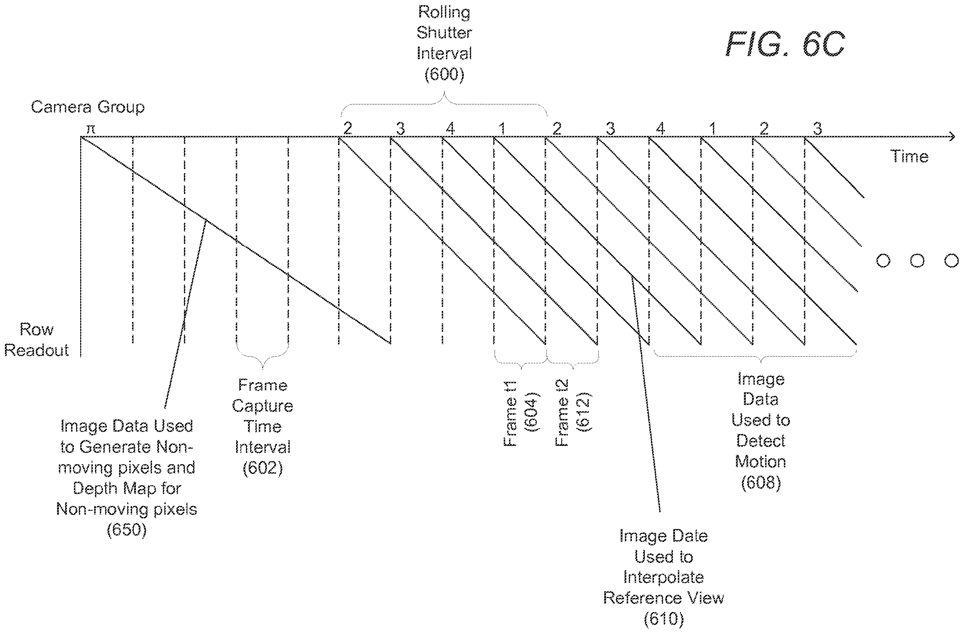

In several embodiments, the complete sets of image data captured by each of the camera groups (1, 2, 3, 4) can be utilized to perform depth estimation with respect to non-moving pixels. In a number of embodiments, an initial group of cameras is utilized to capture a first frame of image data and generate a depth map, and/or confidence for the rendered frame. Smaller groups of cameras can then capture image data used to render moving pixels in subsequent frames. A process of capturing image data using an initial group of cameras corresponding to the 3 x 3 $\pi$ filter group of cameras shown in FIG. 3B and then by the four groups of cameras shown in FIG. 3A in accordance with an embodiment of the invention is illustrated in FIG. 6C. In the illustrated embodiment, image data (650) is captured by the initial 3 x 3 $\pi$ filter group of cameras. The rolling shutter period of the initial 3 x 3 $\pi$ filter group of cameras is shown as longer than that for the smaller groups of cameras (1, 2, 3, 4) used to subsequently capture image data. As noted above, the image data (650) captured by the initial 3 x 3 $\pi$ filter group of cameras can be utilized to render an initial frame and to generate an initial depth map. Moving pixels captured in subsequent frame capture intervals can then be composited with the initial frame of video to render a high frame rate video sequence using techniques similar to those described above. In the illustrated example, the cameras in group 2 (i.e. 304 in FIG. 3A) are not part of the initial 3 x 3 $\pi$ filter group (i.e. 312 in FIG. 3B). Accordingly, image data can be read out from the cameras in group 2 prior to the completion of image data capture by the initial 3 x 3 $\pi$ filter group. In other embodiments, the sequencing of image data capture can be coordinated as appropriate to the requirements of specific applications.

As noted above, the different viewpoints of the camera groups can result in vertical parallax effectively shifting objects at boundaries between the rows of image data captured by different camera groups out of the rendered image. Effectively, objects that are not visible in a first set of rows read out from a first group of cameras may also not be visible in a second sequential group of rows read out from a second group of cameras due to vertical parallax shifting the unobserved pixels into the field of view sampled by the rows (or columns) of the sensors in the second group of cameras during the frame capture time interval. By increasing the number of rows (or columns) read out during a frame capture time interval by an amount corresponding to the likely observed vertical parallax of foreground objects between viewpoints of groups of cameras that sample progressive portions of the scene, then the likelihood of unobserved objects or portions of objects at the boundaries between portions of the scene sampled by different groups of cameras during a display frame interval can be diminished. In many embodiments, more than 1/N of the total number of rows (or columns) of a rendered frame can be read out from each of N groups of cameras during a frame capture time interval to accommodate vertical parallax observable between the viewpoints of the cameras in the different groups of cameras. Readout of approximately 1/3rd of the rows of four groups of cameras during every frame capture interval in accordance with an embodiment of the invention is conceptually illustrated in FIG. 6D. As can readily be appreciated, there is overlap in the sequential groups of rows captured by each of the groups of cameras enabling identification of objects that might otherwise be unobserved due to vertical parallax. Although a specific number of overlapping rows between different groups of cameras is shown in FIG. 6D, the specific amount of overlap is largely dependent upon the requirements of a particular application.

As noted above, vertical parallax can also be accommodated by utilizing additional rows of data captured by a group of cameras during a previous and/or subsequent frame capture time interval. The searching of additional rows (636) captured by a camera group during a previous frame capture interval (630) to the frame capture interval of a rendered frame (632) and/or a subsequent frame capture time interval (634) is conceptually illustrated in FIG. 6E. Objects that might otherwise be unobserved due to vertical parallax can be rendered by searching for the objects in rows captured by the camera group during different frame capture intervals. Viewed another way, the frame capture time intervals could be considered to overlap in the sense that certain rows (or columns) of image data captured by a camera could be used in the rendering of two successive frames in the high speed video sequence in order to accommodate vertical parallax at the boundaries between the portions of a rendered frame captured by different groups of cameras in a manner that is conceptually similar to the readout of more than 1/N of the total number of rows (or columns) of the rendered frame.

Although specific processes for rendering high frame rate video sequences using image data captured by groups of cameras in an array camera are described above with reference to FIG. 5 - 6E, any of a variety of processes can be utilized to concurrently capture and read out image data from multiple different groups of cameras and to combine the image data into frames of video at a rate faster than the rate at which individual cameras in the array camera can capture frames of video appropriate to the requirements of specific applications can be utilized in accordance with embodiments of the invention. For examples, array cameras in accordance with many embodiments utilize cameras having an electronic snap-shot shutter. When cameras in an array have an electronic snap-shot shutter, similar techniques to those described above can be used to interpolate images from different viewpoints for the purpose of performing depth estimation. The depth estimates can then be used to shift pixels captured from alternate viewpoint into the reference viewpoint. In several embodiments, entire frames can be interpolated. In other embodiments, moving pixels can be interpolated and non-moving pixels can be rendered from a previously rendered frame. Accordingly, the specific processes utilized to estimate depth during the capture of high frame rate video sequences using an array camera should be understood to be largely dependent upon the number and type of cameras in the array.

Processes for Estimating Depth using Interpolated Frames

Array cameras in accordance with many embodiments of the invention utilize image data captured by multiple groups of cameras to estimate depth during high frame rate video capture. As noted above, temporal interpolation of frames of video can be extremely useful in depth estimation. In many embodiments, image data from two or more successive frames can be utilized to perform temporal interpolation of the locations of moving pixels at a given frame capture time interval. The interpolated frames act as synthetic alternate views to image data captured during a given frame capture time interval. While errors in accurately estimating the location of moving pixels in an interpolated frame can result in errors in depth estimation, estimation errors are typically small due to the high frame rate of the video. Furthermore, filtering depth estimates at high frame rates can correct for errors. The filtering is also assisted by the fact that different epipolar lines are searched with respect to the cameras in the different groups of cameras over successive frame capture time intervals. Therefore, interpolation errors are unlikely to result in the same depth estimation error with respect to each pair of viewpoints utilized to perform a disparity search for a portion of a rendered frame in each successive time interval. These differences can be utilized during filtering to refine the depth estimate. As noted above, the depth estimates can involve the generation of confidence metrics and the strength of the depth filtering applied can be adapted based upon the confidence of a given depth estimate.

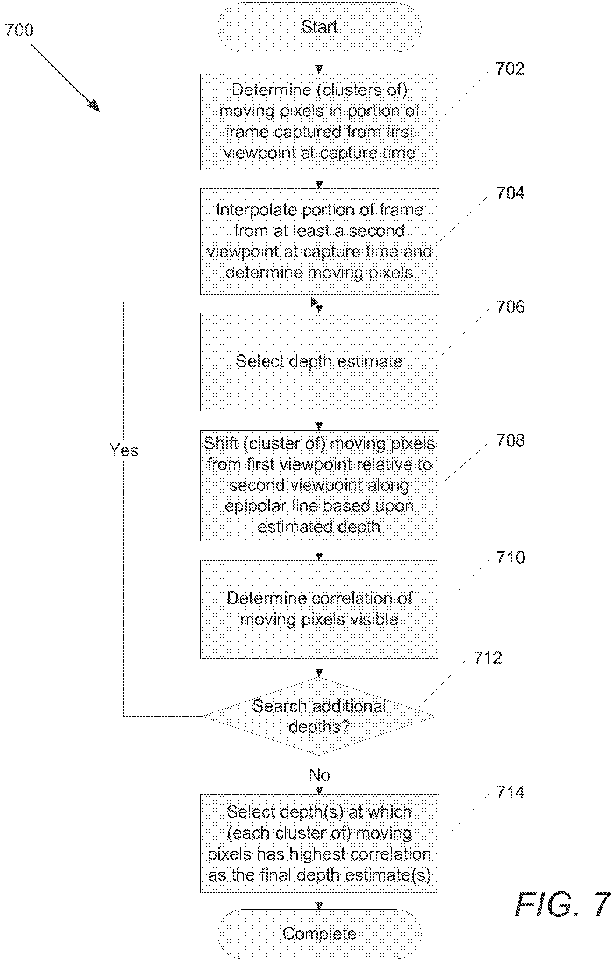

A process for estimating depth using interpolated portions of frames in accordance with an embodiment of the invention is illustrated in FIG. 7. The process 700 includes detecting (702) moving pixels in a portion of a frame from image data captured from a first viewpoint during a given frame capture time interval. The depths of the identified moving pixels can be determined by interpolating (704) a corresponding portion of a frame from at least a second (different) viewpoint at the given frame capture time interval. In many embodiments, the interpolation is only performed with respect to pixels that are identified as moving within image data captured from a second viewpoint. In other embodiments, portions of frames can be interpolated from more viewpoints and/or in multiple color channels to provide a depth estimation that is robust to occlusions.

Disparity searches are typically performed with respect to image data captured from the viewpoints of cameras that capture image data within the same color channel(s). Although, disparity searches can be performed in multiple color channels by comparing the similarity of pixels in each of the color channels. In embodiments where image data from a single group of cameras is utilized to render the non-moving pixels from the reference viewpoint, cameras in other groups of cameras typically utilize portions of frames interpolated from at least the reference viewpoint to perform depth estimates. In circumstances where none of the cameras in a given color channel capture image data from the reference viewpoint, then at least one portion of a frame can be interpolated from the viewpoint of a camera that captures image data in the relevant color channel from the group of cameras used to render the non-moving pixels from the reference viewpoint. Where a camera in the group of cameras used to render the non-moving pixels from the reference viewpoint captures image data from the reference viewpoint, the depth of moving pixels observed by the camera from the reference viewpoint can be determined by interpolating a corresponding portion of a frame at the given frame capture time interval using image data captured from within the same color channel(s) by a camera with an alternate viewpoint. In many embodiments, the interpolation process is a bimodal interpolation process. In other embodiments, the interpolation process can be any of a variety of interpolation processes appropriate to the requirements of specific applications including (but not limited to) trimodal interpolation processes.

Where motion is assumed unconstrained, depth estimates can be obtained by performing disparity searches with respect to individual moving pixels. Where moving pixels are assumed to be part of objects, disparity searches can be performed with respect to clusters of moving pixels. Where all motion is assumed to occur on the same plane, disparity searches can be performed with respect to the entire set of moving pixels. The process of performing a disparity search with respect to pixels in a first viewpoint can involve selecting (706) an initial depth estimate and shifting the searched pixels from at least a second viewpoint into the first viewpoint. Comparisons can also be performed between portions of images captured from different viewpoints in other color channels. From there, a comparison can be performed using any of a variety of metrics including (but not limited to) those described in U.S. Patent 8,619,082. Where disparity searches are performed with respect to a set or cluster of pixels, then correlation can be used to determine (710) the similarity of two clusters of pixels. The process is repeated at a variety of depth samples until a determination (712) is made that a sufficient number of depth samples have been searched. At which point, the depth at which the chosen metric indicates the highest degree of similarity can be selected (714) as the depth estimate for the pixel, cluster of pixels and/or set of pixels. A confidence metric can be assigned to each depth estimate. The specific confidence metric utilized can depend upon the similarity measure utilized to perform the disparity search and the requirements of specific applications. In many embodiments, confidence metrics including (but not limited to) the confidence metrics described in U.S. Patent 8,619,082 and in Xiaoyan Hu, P. Mordohai, "A Quantitative Evaluation of Confidence Measures for Stereo Vision", IEEE Transactions on Pattern Analysis & Machine Intelligence, vol.34, no. 11, pp. 2121-2133, Nov. 2012, doi:10.1109/TPAMI.2012.46 can be utilized to encode confidence metrics for depth estimates generated utilized by processes similar to those described above.

**Claims**

1. An array camera (100), comprising:

> a plurality of cameras (104) that capture images of a scene from different viewpoints;
> a processor (106); and memory (108) containing an image processing pipeline application (110); wherein the image processing pipeline application (110) directs the processor (106) to:

>> obtain image data (606) from a plurality of groups of cameras (302-308) from within the plurality of cameras (104), where each group of cameras starts capturing image data at a staggered start time relative to the other groups of cameras;
>> select a reference viewpoint (412) and determine scene-dependent geometric corrections that shift pixels captured from an alternate viewpoint (414) to the reference viewpoint (412) by performing disparity searches to identify the disparity at which pixels from the different viewpoints are most similar, wherein performing the disparity searches comprises:

>>> selecting moving pixels from image data captured from a first viewpoint during a given frame capture time interval, where the moving pixels are pixels determined to be moving during at least the specific frame capture time interval, interpolating moving pixels from a second viewpoint during the specific frame capture time interval based upon image data captured from the second viewpoint at other times, where the second viewpoint differs from the first viewpoint, and
>>> identifying the disparity at which the moving pixels from image data captured from the first viewpoint and the moving pixels interpolated from the second viewpoint are most similar; and

>> render frames of video by shifting pixels captured from alternate viewpoints to the reference viewpoint using the scene-dependent geometric corrections determined for the pixels captured from the alternate viewpoint, where a given frame of video is rendered using pixels comprising:

>>> the moving pixels (608) captured during said given frame capture time interval; and
>>> pixels (606) from a previously rendered frame that are determined to be non-moving during at least the given frame capture time interval.

2. The array camera of claim 1, wherein each group of cameras comprises at least one camera selected from the group consisting of: a monochrome camera, a Bayer camera, and an infrared camera.

3. The array camera of claim 1, wherein the first viewpoint is the alternate viewpoint, and the second viewpoint is the reference viewpoint.

4. The array camera of claim 3, wherein the plurality of cameras comprises a camera that captures image data from the reference viewpoint.

5. The array camera of claim 1, wherein the image processing pipeline application further directs the processor to perform a disparity search to identify the disparity at which the moving pixels from image data captured from the first viewpoint and the moving pixels interpolated from the second viewpoint are most similar by comparing the similarity of a set of moving pixels at different disparities.

6. The array camera of claim 1, wherein:

the plurality of cameras have electronic rolling shutters;
the given frame capture time interval is shorter than a rolling shutter time interval, where the rolling shutter time interval is the time taken to complete read out of image data from a camera in the plurality of cameras;
the staggered start times of the cameras are coordinated so that each of N groups of cameras captures at least a 1/N portion of an image during a given frame capture time interval; and
a given frame of video is rendered using pixels comprising pixels from the N groups of cameras captured during the given frame capture time interval.

7. The array camera of claim 1, wherein the plurality of cameras have electronic snap-shot shutters.

8. The array camera of claim 1, wherein the image processing pipeline application further directs the processor to determine the scene-dependent geometric corrections that shift pixels captured from an alternate viewpoint to the reference viewpoint by estimating depths for a set of said moving pixels determined to be moving during the given frame capture time interval based on said identified disparity.

**Patentansprüche**

1. Flächenkamera (100), die Folgendes umfasst:

mehrere Kameras (104), die Bilder einer Szene aus verschiedenen Blickpunkten aufnehmen;
einen Prozessor (106); und
Speicher (108), der eine Bildverarbeitungs-Pipeline-Anwendung (110) enthält;
wobei die Bildverarbeitungs-Pipeline-Anwendung (110) den Prozessor (106) anweist, Folgendes durchzuführen:

Erhalten von Bilddaten (606) von mehreren Gruppen von Kameras (302-308) aus den mehreren Kameras (104), wobei jede Gruppe von Kameras eine Aufnahme von Bilddaten zu einer versetzten Startzeit relativ zu den anderen Gruppen von Kameras beginnt;
Auswählen eines Referenzblickpunkts (412) und Bestimmen szenenabhängiger geometrischer Korrekturen, die Pixel, die aus einem alternativen Blickpunkt (414) aufgenommen werden, zu dem Referenzblickpunkt (412) verschieben, durch Durchführen von Disparitätssuchen, um die Disparität zu identifizieren, bei der Pixel aus den verschiedenen Blickpunkten am ähnlichsten sind, wobei das Durchführen der Disparitätssuchen Folgendes umfasst:

Auswählen von sich bewegenden Pixeln aus Bilddaten, die aus einem ersten Blickpunkt während eines gegebenen Einzelbildaufnahmezeitintervalls aufgenommen werden, wobei die sich bewegenden Pixel Pixel sind, von denen bestimmt wurde, dass sie sich während wenigstens des spezifischen Einzelbildaufnahmezeitintervalls bewegen,
Interpolieren von sich bewegenden Pixeln aus einem zweiten Blickpunkt während des spezifischen Einzelbildaufnahmezeitintervalls basierend auf Bilddaten, die aus dem zweiten Blickpunkt zu anderen Zeiten aufgenommen werden, wenn der zweite Blickpunkt von dem ersten Blickpunkt verschieden ist, und
Identifizieren der Disparität, bei der die sich bewegenden Pixel aus Bilddaten, die aus dem ersten Blickpunkt aufgenommen werden, und den sich bewegenden Pixeln, die aus dem zweiten Blickpunkt interpoliert werden, am ähnlichsten sind; und

Rendern von Videoeinzelbildern durch Verschieben von Pixeln, die aus alternativen Blickwinkeln aufgenommen werden, zu dem Referenzblickpunkt unter Verwendung der szenenabhängigen geometrischen Korrekturen, die für die Pixel bestimmt werden, die aus dem alternativen Blickwinkel aufgenommen werden, wobei ein gegebenes Videoeinzelbild unter Verwendung von Pixeln gerendert wird, die Folgendes umfassen:

die sich bewegenden Pixel (608), die während des gegebenen Einzelbildaufnahmezeitintervalls aufgenommen werden; und
Pixel (606) von einem zuvor gerenderten Einzelbild, von denen bestimmt wird, dass sie sich während wenigstens des gegebenen Einzelbildaufnahmezeitintervalls nicht bewegen.

2. Flächenkamera nach Anspruch 1, wobei jede Gruppe von Kameras wenigstens eine Kamera umfasst, die aus der Gruppe ausgewählt ist, die auf Folgendem besteht: einer Monochromkamera, einer Bayer-Kamera und einer Infrarotkamera.

3. Flächenkamera nach Anspruch 1, wobei der erste Blickpunkt der alternative Blickpunkt ist und der zweite Blickpunkt der Referenzblickpunkt ist.

4. Flächenkamera nach Anspruch 3, wobei die mehreren Kameras eine Kamera umfasst, die Bilddaten aus dem Referenzblickpunkt aufnimmt.

5. Flächenkamera nach Anspruch 1, wobei die Bildverarbeitungs-Pipeline-Anwendung den Prozessor weiter anweist, eine Disparitätssuche durchzuführen, um die Disparität zu identifizieren, bei der die sich bewegenden Pixel aus Bilddaten, die aus dem ersten Blickpunkt aufgenommen werden, und die sich bewegenden Pixel, die aus dem zweiten Blickpunkt interpoliert werden, am ähnlichsten sind, durch Vergleichen der Ähnlichkeit eines Satzes sich bewegender Pixel bei verschiedenen Disparitäten.

6. Flächenkamera nach Anspruch 1, wobei:

die mehreren Kameras elektronische Verschlüsse aufweisen;
das gegebene Einzelbildaufnahmezeitintervall kürzer ist als ein Rolling-Shutter-Zeitintervall, wobei das Rolling-Shutter-Zeitintervall die Zeit ist, die benötigt wird, um ein Auslesen von Bilddaten aus einer Kamera in den mehreren Kameras abzuschließen;
die versetzten Startzeiten der Kameras koordiniert werden, so dass jede von N Gruppen von Kameras wenigstens einen 1/N-Abschnitt eines Bildes während eines gegebenen Einzelbildaufnahmezeitintervalls aufnimmt; und
ein gegebenes Videoeinzelbild unter Verwendung von Pixeln gerendert wird, die Pixel aus den N Gruppen von Kameras umfassen, die während des gegebenen Einzelbildaufnahmezeitintervalls aufgenommen werden.

7. Flächenkamera nach Anspruch 1, wobei die mehreren Kameras elektronische Schnappschussverschlüsse aufweisen.

8. Flächenkamera nach Anspruch 1, wobei die Bildverarbeitungs-Pipeline-Anwendung den Prozessor ferner anweist, die szenenabhängigen geometrischen Korrekturen zu bestimmen, die Pixel, die aus einem alternativen Blickpunkt aufgenommen werden, zu dem Referenzblickpunkt verschieben, durch Schätzen von Tiefen für einen Satz der sich bewegenden Pixel, von denen bestimmt wird, dass sie sich während des gegebenen Einzelbilderfassungszeitintervalls basierend auf der identifizierten Disparität bewegen.

**Revendications**

1. Caméra matricielle (100), comprenant :

une pluralité de caméras (104) qui capturent des images d'une scène à partir de différents points de vue ;
un processeur (106) ; et
une mémoire (108) contenant une application pipeline de traitement d'image (110) ;
l'application pipeline de traitement d'image (110) amenant le processeur (106) à :

obtenir des données d'image (606) à partir d'une pluralité de groupes de caméras (302-308) provenant de la pluralité de caméras (104), chaque groupe de caméras commençant à capturer des données d'image à un moment de début échelonné par rapport aux autres groupes de caméras ;
sélectionner un point de vue de référence (412) et déterminer des corrections géométriques dépendant de la scène qui déplacent les pixels capturés à partir d'un point de vue alternatif (414) au point de vue de référence (412) en effectuant des recherches de disparité pour identifier la disparité à laquelle les pixels des différents points de vue sont les plus similaires, le fait d'effectuer des recherches de disparité comprenant :

la sélection de pixels mobiles à partir de données d'image capturées à partir d'un premier point de vue pendant un intervalle de temps de capture de trame donné, les pixels mobiles étant des pixels déterminés comme étant en mouvement pendant au moins l'intervalle de temps de capture de trame spécifique,

l'interpolation des pixels mobiles à partir d'un second point de vue pendant l'intervalle de temps de capture de trame spécifique sur la base de données d'image capturées à partir du second point de vue à d'autres moments, le second point de vue différant du premier point de vue, et

l'identification de la disparité à laquelle les pixels mobiles provenant des données d'image capturées à partir du premier point de vue et les pixels mobiles interpolés à partir du second point de vue sont les plus similaires ; et

le rendu des trames vidéo en déplaçant les pixels capturés à partir des points de vue alternatifs vers le point de vue de référence à l'aide des corrections géométriques dépendantes de la scène déterminées pour les pixels capturés à partir du point de vue alternatif, une trame vidéo donnée étant rendue à l'aide des pixels comprenant :

les pixels mobiles (608) capturés pendant ledit intervalle de temps de capture de trame donné ; et des pixels (606) provenant d'une image rendue précédemment qui sont déterminés comme étant immobiles pendant au moins l'intervalle de temps de capture d'image donné.

2. Caméra matricielle selon la revendication 1, chaque groupe de caméras comprenant au moins une caméra sélectionnée dans le groupe constitué : d'une caméra monochrome, d'une caméra Bayer et d'une caméra infrarouge.

3. Caméra matricielle selon la revendication 1, le premier point de vue étant le point de vue alternatif, et le second point de vue étant le point de vue de référence.

4. Caméra matricielle selon la revendication 3, la pluralité de caméras comprenant une caméra qui capture des données d'image à partir du point de vue de référence.

5. Caméra matricielle selon la revendication 1, l'application pipeline de traitement d'image amenant en outre le processeur à effectuer une recherche de disparité pour identifier la disparité à laquelle les pixels mobiles provenant des données d'image capturées à partir du premier point de vue et les pixels mobiles interpolés à partir du second point de vue sont les plus similaires en comparant la similitude d'un ensemble de pixels mobiles à différentes disparités.

6. Caméra matricielle selon la revendication 1 :

la pluralité de caméras présentant des obturateurs roulants électroniques ;
l'intervalle de temps de capture d'image donné étant plus court qu'un intervalle de temps d'obturateur roulant, l'intervalle de temps d'obturateur roulant étant le temps pris pour terminer la lecture des données d'image provenant d'une caméra dans la pluralité de caméras ;
les moments de début échelonnés des caméras étant coordonnés de sorte que chacun des N groupes de caméras capture au moins une partie 1/N d'une image pendant un intervalle de temps de capture de trame donné ; et
une trame vidéo donnée étant rendue à l'aide de pixels comprenant des pixels provenant des N groupes de caméras capturés pendant l'intervalle de temps de capture de trame donné.

7. Caméra matricielle selon la revendication 1, la pluralité de caméras présentant des obturateurs de prise de vue électroniques.

8. Caméra matricielle selon la revendication 1, l'application pipeline de traitement d'image amenant en outre le processeur à déterminer les corrections géométriques dépendant de la scène qui déplacent les pixels capturés à partir d'un point de vue alternatif au point de vue de référence en estimant des profondeurs pour un ensemble desdits pixels mobiles déterminés comme étant en mouvement pendant l'intervalle de temps de capture de trame donné sur la base de ladite disparité identifiée.

*FIG. 1*

*FIG. 2*

*FIG. 3A*

EP 3 284 061 B1

| | | | |
|---|---|---|---|
| G | B | G | R |
| R | G | R | G |
| G | B | G | B |
| B | G | R | G |

FIG. 3B

312

310

300

*FIG. 4A*

*FIG. 4B*

*FIG. 4C*

EP 3 284 061 B1

500

Start

502 — Capture image data using each camera group over successive rolling shutter intervals

504 — Photometric and geometric normalization

506 — Motion detection

508 — Estimate depth of motion

510 — Estimate depth of non-moving portions of scene (optional)

512 — Parallax correction

514 — Filter depth estimates across frames (optional)

516 — Render frames using image data from successive frame capture time intervals

518 — Capture complete?

No

Yes

Complete

*FIG. 5*

Camera Group

Row Readout

Image Date Used to Generate Background (606)

Rolling Shutter Interval (600)

Frame t1 (604)

Frame t2 (612)

Image Date Used to Interpolate Reference View (610)

Image Data Used to Detect Motion (608)

Frame Capture Time Intervall (602)

Time

*FIG. 6A*

Row Refresh

Display Refresh Interval (620)

Latency (624)

Frame t1 (622)

Frame t2 (626)

Time

*FIG. 6B*

FIG. 6C

Rolling Shutter Interval (600)

Camera Group

Time

Row Readout

Image Data Used to Generate Non-moving pixels and Depth Map for Non-moving pixels (650)

Frame Capture Time Interval (602)

Frame t1 (604)

Frame t2 (612)

Image Date Used to Interpolate Reference View (610)

Image Data Used to Detect Motion (608)

EP 3 284 061 B1

FIG. 6D

EP 3 284 061 B1

Camera Group

4   1   2   Time

Additional rows searched from camera group 4 (636)

Additional rows searched from camera group 4 (636)

Additional rows searched from camera group 4 (636)

Interval t-1 (630)

Interval t (632)

Interval t+1 (634)

*FIG. 6E*

700

Start

Determine (clusters of) moving pixels in portion of frame captured from first viewpoint at capture time — 702

Interpolate portion of frame from at least a second viewpoint at capture time and determine moving pixels — 704

Select depth estimate — 706

Shift (cluster of) moving pixels from first viewpoint relative to second viewpoint along epipolar line based upon estimated depth — 708

Determine correlation of moving pixels visible — 710

Search additional depths? — 712

Yes

No

Select depth(s) at which (each cluster of) moving pixels has highest correlation as the final depth estimate(s) — 714

Complete

*FIG. 7*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011080487 A
- WO 2011121117 A
- US 8619082 B, Ciurea
- US 20140267243 A, Venkataraman
- US 20110069189 A, Venkataraman
- US 20120013748 A, Pain
- US 53655414, Rodda
- US 20140293760 A, Nisenzon
- US 61775395
- US 20120147205 A, Lelescu

**Non-patent literature cited in the description**

- **SCHECHTMAN et al.** Increasing Space-Time Resolution in Video. *European Conference on Computer Vision (ECCV),* May 2002
- **WILBURN et al.** High-Speed Videography using a Dense Camera Array. *IEEE Society Conference on Pattern Recognition,* 2004
- **XIAOYAN HU, P. MORDOHAI.** A Quantitative Evaluation of Confidence Measures for Stereo Vision. *IEEE Transactions on Pattern Analysis & Machine Intelligence,* November 2012, vol. 34 (11), 2121-2133